# EUROPEAN PATENT APPLICATION

(11) **EP 4 685 560 A2**
(43) Date of publication of application: **28.01.2026**
(21) Application number: 25222227.8
(22) Date of filing: 10.12.2025
(51) Int. Cl.: G03F 7/00

(54) **COLOR SELECTION MODULE**

(71) Applicant: ASML Netherlands B.V., 5500 AH Veldhoven (NL)
(72) Inventor: ZHOU, Zili, 5500 AH Veldhoven (NL); OZTURK, Fahri Emre, 5500 AH Veldhoven (NL); CSISZAR, Szilard, Istvan, 5500 AH Veldhoven (NL); UYSALLI, Yigit, 5500 AH Veldhoven (NL)
(74) Representative: ASML Netherlands B.V.

(57) **Abstract**

This application provides a color selection module, and a method, for filtering a radiation beam having radiation comprising a wavelength band. The color selection module comprises: a first reflector; a second reflector and an optical filter. The first reflector has selectable configurations and is configured to receive the radiation beam and direct the radiation beam towards the optical filter. The selectable configurations control a first impinging characteristic of the radiation beam. The optical filter is configured to depending on the first impinging characteristic of the radiation beam selectively transmit a first transmitted radiation beam and reflect a first reflected radiation beam. The second reflector is configured to receive the first reflected radiation beam and direct the first reflected radiation beam towards the optical filter. The optical filter is further configured to depending on a second impinging characteristic of the first reflected beam selectively transmit a second transmitted radiation beam.

## Description

### FIELD

The present invention relates to color selection module for filtering a radiation beam, a metrology tool or inspection tool comprising the color selection module, a lithographic apparatus comprising the color selection module and a method for filtering a radiation beam having radiation comprising a wavelength band.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

In lithographic processes, it is desirable to make frequently measurements of the structures or patterns created, e.g., for process control and verification. Tools to make such measurement are typically called metrology tools or metrology devices. To perform such measurements it is of interest to be able to select a color of a radiation beam, the radiation beam having radiation comprising a wavelength band. Typically a color selection module is used to select one portion of the wavelength band of the radiation of the radiation beam. In certain situations it can be of interest to select a second color or more colors for sequential or parallel measurements with more than one color, for example because the measurement efficiency or accuracy is color dependent.

Patent publication document US 11662562 B2 discloses a tunable color filter having a first adjustable mirror that receives an input beam from a broadband illumination source containing spectrum of wavelengths in the visible spectrum and directs this input beam towards a linearly-varying filter. This linearly-varying filter filters a bandwidth of the spectrum of wavelength where the filtering is based on the spatial position on the linearly-varying filter. The spatial position on the linearly-varying filter is selectable based on an angle of the first adjustable mirror. After the input beam has passed the linearly-varying filter, a filtered output beam with the selected wavelength spectrum bandwidth continuous towards a second adjustable mirror which receives this filtered output beam. The second adjustable mirror directs the filtered output beam along an output path selectable based on an angle of the second adjustable mirror. A downside of this known example is that only a single color can be selected to be used in a measurement. A further downside is that the unwanted reflected light, i.e., the bandwidth or bandwidths of the spectrum of the wavelength of the light beam that is or are not passed through the linearly-varying filter, is not used and discarded. For example, the reflected light is sent to a beam dump without further use resulting in an inefficient use of the unfiltered input beam. The patent publication document US 11662562 B2 is incorporated herein by reference.

### SUMMARY

According to a first aspect of the invention, there is provided a color selection module for filtering a radiation beam, the radiation beam having radiation comprising a wavelength band. The color selection module comprises a first reflector and an optical filter. The first reflector has selectable configurations, the selectable configurations controlling a first impinging characteristic of the radiation beam. The first reflector is further configured to receive the radiation beam and direct the radiation beam towards the optical filter. The optical filter is configured to depending on the first impinging characteristic of the radiation beam selectively transmit a first transmitted radiation beam. This first transmitted radiation beam comprises a first portion of the wavelength band and reflect a first reflected radiation beam comprising a second portion of the wavelength band. The color selection module further comprises a second reflector. The second reflector is configured to receive the first reflected radiation beam and direct the first reflected radiation beam towards the optical filter. The optical filter is then further configured to depending on a second impinging characteristic of the first reflected beam selectively transmit a second transmitted radiation beam comprising a third portion of the wavelength band.

Advantageously having the second reflector enables a second filtering of the wavelength band of the radiation of the radiation beam in an efficient manner by reusing the reflected light returning from the filter instead of sending it to a beam dump. Here a part of this reflected light is used to do a second filtering resulting in a second filtering of the wavelength band of the radiation of the radiation beam. This then results in more than one color being selected from the unfiltered radiation beam.

In an embodiment the first impinging characteristic of the radiation beam and/or the second impinging characteristic of the first reflected beam is a selectable position on the optical filter. An effect of this embodiment is that a transmitted radiation beam comprising a portion of the wavelength can be selected by selecting a position on the optical filter.

In an embodiment the first impinging characteristic of the radiation beam and/or the second impinging characteristic of the first reflected beam is an angle of incidence of the radiation beam or the first reflected radiation beam on the optical filter. An effect of this embodiment is that a transmitted radiation beam comprising a portion of the wavelength can be selected by adapting the angle of incidence of the radiation beam with respect to the optical filter.

In an embodiment the second reflector has selectable configurations and the optical filter is further configured to selectively transmit the second transmitted radiation beam comprising the third portion of the wavelength band depending on the second impinging characteristic of the first reflected radiation beam. An effect of this embodiment is that also for the second transmitted radiation beam, and thus selected color, the filtering can be done selectively.

In an embodiment the color selection module further comprises a routing module configured to receive and transmit one or more of the transmitted radiation beams towards an output. Having more than one color being selected from the unfiltered radiation beam, this enables several options for the output of the filtered transmitted radiation beams or selected colors. A first option is to direct all the filtered transmitted radiation beams towards the same output enabling parallel multicolor measurements. A second option is to direct one or more of the filtered transmitted radiation beams towards one or more different outputs. The routing of the transmitted radiation beams can be done using the routine module. This routing module may for example comprise optical elements to manipulate the transmitted radiation beams towards the output or this routing module may comprise a shutter array to selectively pass or block a transmitted radiation beam.

According to a second aspect of the invention, there is provided a method for filtering a radiation beam having radiation comprising a wavelength band, the method comprising: receiving and directing the radiation beam with a first reflector towards an optical filter, the first reflector having selectable configurations. Controlling a first impinging characteristic of the radiation beam with the selectable configurations of the first reflector. Selectively transmitting a first transmitted radiation beam with the optical filter depending on the first impinging characteristic of the radiation beam, the first transmitted radiation beam comprising a first portion of the wavelength band. Selectively reflecting a first reflected radiation beam comprising a second portion of the wavelength band. Receiving and directing the first reflected radiation beam towards the optical filter. Selectively transmitting a second transmitted radiation beam with the optical filter depending on a second impinging characteristic of the first reflected radiation beam, the second transmitted radiation beam comprising a third portion of the wavelength band.According to a third aspect of the invention, there is provided a metrology tool or inspection tool comprising the color selection module.

According to a fourth aspect of the invention, there is provided a lithographic apparatus comprising the color selection module.

According to a fifth aspect of the invention, there is provided a lithographic cell comprising the color selection module.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a metrology apparatus;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6(a) depicts a schematic overview of a color selection module for filtering a radiation beam having radiation comprising a wavelength band.
- Figure 6(b) depicts a schematic overview of a color selection module for filtering a radiation beam having radiation comprising a wavelength band with a change in the first impinging characteristic of the radiation beam.
- Figure 7 depicts a color selection module which is a variation of the color selection module as shown an described of figure 6(a) where the second reflector may have selectable configurations.
- Figure 8 depicts a schematic overview of an example routing module.
- Figure 9 depicts a schematic overview of another example routing module.
- Figure 10 depicts a depicts a schematic overview a method for filtering a radiation beam having radiation comprising a wavelength band.

### DETAILED DESCRIPTION

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

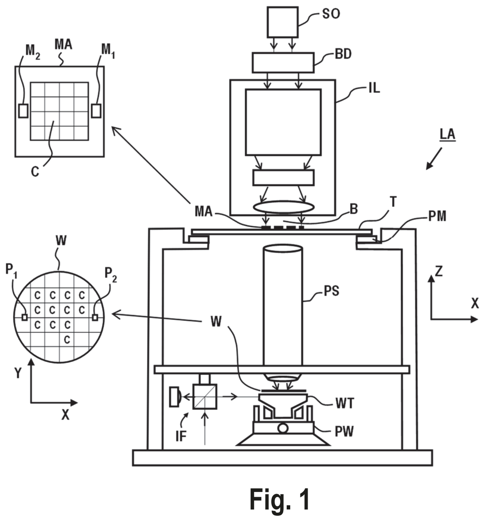

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

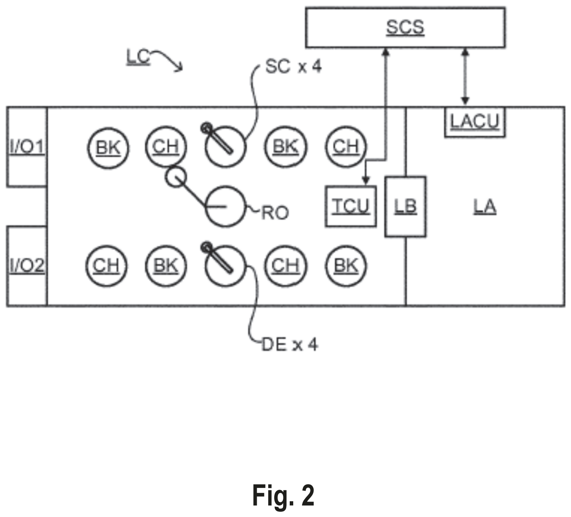

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

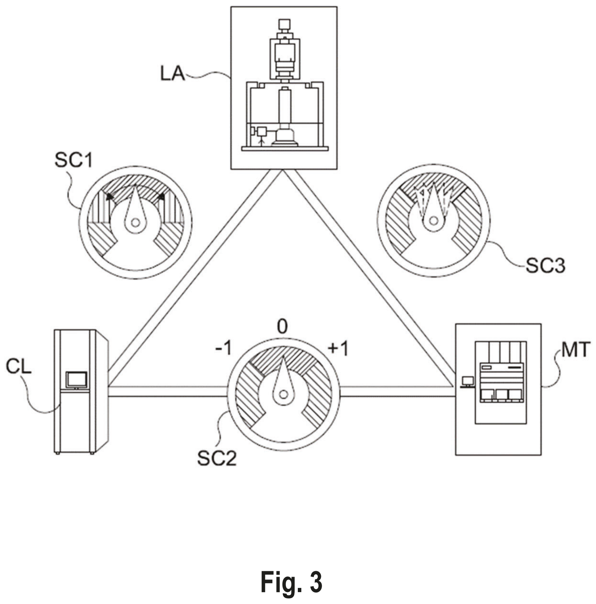

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time. An example of such multiple target measurements can be found in US patent application US..., incorporated herein by reference in its entirety.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and not yet published US patent application 15/181,126, incorporated herein by reference in its entirety.

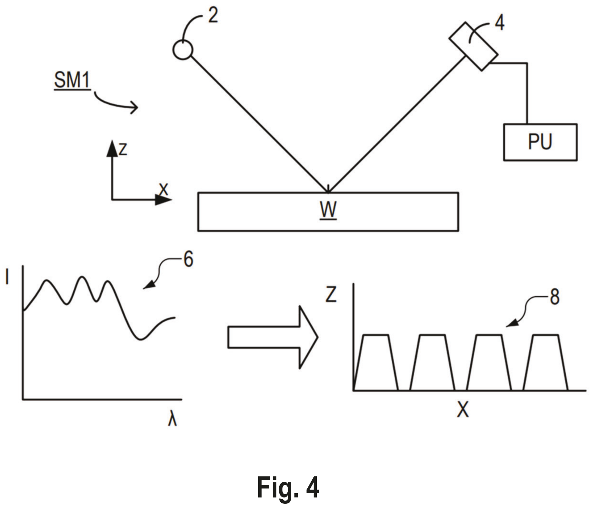

A metrology apparatus, such as a scatterometer, is depicted in figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

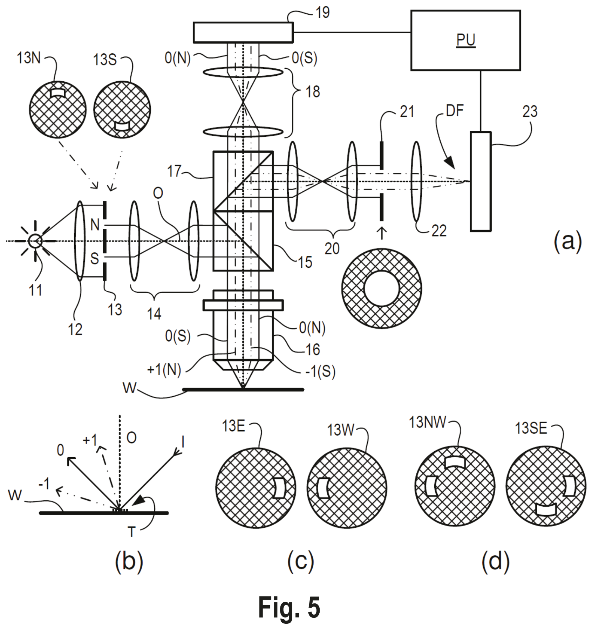

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

The radiation of the radiation source SO may be modified by various types of optical components, such as refractive, reflective, magnetic, electromagnetic, electrostatic, and/or other types of optical components, or any combination thereof, for directing, shaping, and/or controlling radiation and/or optical parameters of the radiation. The radiation may be in the form of a radiation beam, sometimes also referred to as an illumination beam or measurement radiation or measurement beam. These terms may be used interchangeably throughout this specification. Furthermore, the illumination beam may be pulsed or continuous light. In the case of a pulsed light the optical components may also modify the lengths and/or timing of the pulses.

Several parameters of the radiation or illumination beam may be modified, controlled or conditioned before or after the illumination beam interacts with a part of the substrate W. The radiation beam may be conditioned to have a desired spatial and angular intensity distribution in a plane that presents the spatial spectrum of the substrate plane, here referred to as a (conjugate) pupil plane. its cross section at a plane of the substrate. Other parameters may include a wavelength of measurement radiation, and/or a polarization of measurement radiation, and/or measurement radiation intensity distribution, and/or an illumination angle (e.g., incident angle, azimuth angle, etc.) relative to the substrate of measurement radiation, and/or the relative orientation relative to a pattern on the substrate of diffracted measurement radiation, and/or number of measured points or instances of the target, and/or the locations of instances of the target measured on the substrate.

It may be of interest, depending on the measurement target and the properties to be measured, to use different types of radiation or radiation with different parameters.

Metrology and/or inspection apparatuses (also referred to as measurement apparatuses or assessment apparatuses) such as the ones described above often use radiation to obtain measurement data. Such a metrology and/or inspection apparatuses may also be referred to as metrology and/or inspection tools or metrology and/or inspection devices. Depending on the measurement target and the properties to be measured, different types of radiation may be used. One differing property of radiation is the wavelength(s) or color(s) used to obtain a measurement, as different wavelengths may provide different information about a measurement target, for example because different materials of the sample to be measured may interact in different ways with the different wavelengths or colors of the light. Some measurement tools may use broadband radiation, such as supercontinuum radiation, either to measure using broadband radiation, or to be able to tune and select the measurement wavelength(s) to be used. Depending on the range of output wavelengths and properties of the broadband source, different methods may be used to obtain the broadband radiation. In some implementations for generating broadband radiation, nonlinear effects may be used to broaden narrow wavelength range input radiation (also referred to as pump radiation). Different known setups and methods exist to achieve nonlinear broadening. Often these methods rely on the confinement of the pump radiation to achieve high intensities needed to experience significant nonlinear effects. Other implementations might use a laser produced plasma for generating broadband radiation.

Embodiments of the invention may advantageously provide a radiation source that is able to switch between desired wavelengths - i.e. desired central wavelength and desired spectral bandwidth. In order to provide a radiation source that is able to switch between desired wavelengths, the radiation source may include a color selection module, which may also be referred to as but not limited to a wavelength selection module, wavelength band selection system or module, frequency switch module, spectral shape controller. Such a system or module may be suitable to select a wavelength of interest in the range of, say, 405-790 nm or even lower, such as 200-300 nm, or even higher, in the Infra-Red range of wavelengths, for example up to 1600 nm.

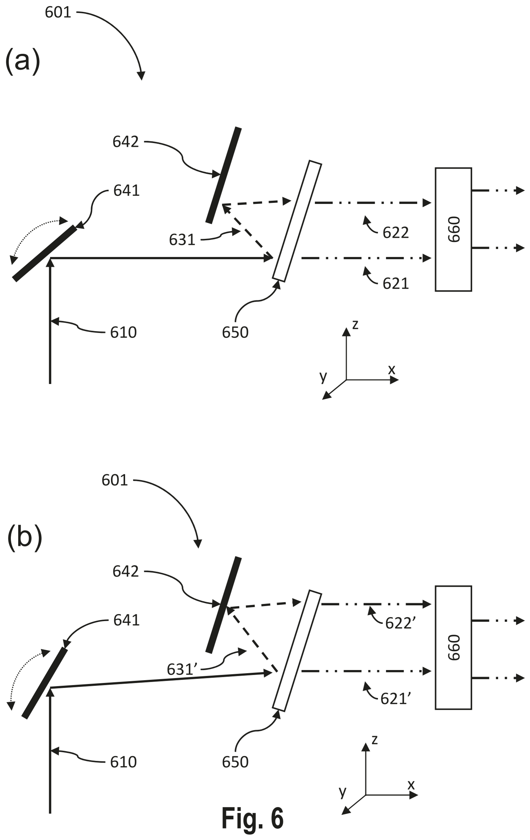

Figure 6(a) depicts a schematic overview of a color selection module (601) for filtering a radiation beam (610) having radiation comprising a wavelength band.

A wavelength band can also be referred to as a spectral band, and can be understood as comprising a central wavelength and a spectral bandwidth. The central wavelength will typically be the wavelength having the highest relative intensity within a wavelength band, but more generally this is the power-weighted mean wavelength within the wavelength band. The bandwidth can typically be defined as the full width at half maximum (FWHM) of the spectral band. An example of such a wavelength band can then for example be a central wavelength of 550 nm with a bandwidth of 100 nm, or a central wavelength of 650 nm with a bandwidth of 5 nm. Such a wavelength band may resemble a Gaussian-distribution on the wavelength-intensity spectrum.

In a first embodiment as schematically depicted in figures 6(a) and 6(b) the color selection module (601) comprises a first reflector (641), a second reflector (642) and an optical filter (650). The first reflector (641) has selectable configurations and is configured to receive the radiation beam (610). The first reflector (641) is further configured to direct the radiation beam (610) towards the optical filter (650).

The radiation beam may be characterized by the radiation being broadband radiation, such as supercontinuum radiation. This may be characterized by the wavelength band of the radiation of the radiation beam being in the visible light spectrum range, or being in the range of, say, 405-790 nm or even lower, such as 200-300 nm, or even higher, in the Infra-Red range of wavelengths, for example up to 1600 nm.

The first reflector (641) and second reflector (642) can be any element or module that is configured to reflect or scatter radiation. Such reflectors can for example be, but are not limited to, flat mirrors, concave or convex curved mirrors or gratings. Such a reflector can for example also be an actuatable mirror such as for example a galvanometer mirror, MEMS mirror, piezoelectric actuated mirror, or similar.

In an embodiment the selectable configurations of the first reflector (641) may be multiple well defined positions of the first reflector (641). Such a defined position may for example be a tilt position around a holding or mounting point of the first reflector (641). The first reflector (641) can then move between these tilt positions to select a selectable configuration. This may be further referred to as a pre-configured position of the first reflector (641).

Such a pre-configured position can further more for example be a position of the first reflector along one of the axes x, y or z. Additionally, such a pre-configured position can for example be a position of the first reflector on one of the planes x-y, x-z or y-z. Additionally, such a pre-configured position can for example be a position of the first reflector in the x-y-z space.

Furthermore, the tilt position around a holding point or mounting point of the first reflector is then around one or more of the axes x, y or z.

It will be appreciated that the pre-configured position of the first reflector can also be at a combination of a position as described above and a tilt position as described above.

In an embodiment the selectable configurations of the first reflector (641) may be a continuous range of positions of the first reflector (641).

. Such a continuous range of positions can for example be a continuous range of positions of the first reflector along one of the axes x, y or z. Additionally, such a continuous range of positions can for example be a continuous range of positions of the first reflector on one of the planes x-y, x-z or y-z. Additionally, such a continuous range of positions can for example be a continuous range of positions of the first reflector in the x-y-z space.

Furthermore, the continuous range of positions of the first reflector can also be a tilt position around a holding point or mounting point of the first reflector around one or more of the axes x, y or z. For example, the first reflector (641) can change tilt over a continuum of angles with each different angle being a different selectable configuration.

It will be appreciated that the continuous range of positions of the first reflector can also be at a combination of a continuous range of positions as described above and a continuous range of tilt positions as described above.

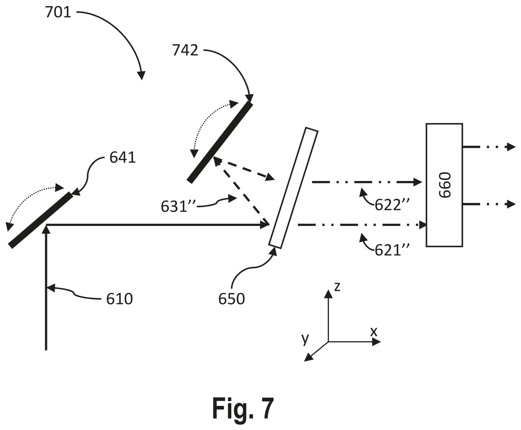

Similarly, in an embodiment, the described selectable configurations may also be applied to the second reflector (642) as will be discussed in the context of figure 7. It is however not necessary for the second reflector (642) to have selectable configurations. In such embodiments the second reflector (642) may be referred to as being static in such an embodiment.

The selectable configurations of the first reflector (641) are for controlling a first impinging characteristic of the radiation beam (610). The optical filter (650) is configured to depending on the impinging characteristic of the radiation beam (610) selectively transmit a first transmitted radiation beam (621) and reflect a first reflected radiation beam (631).

The first transmitted radiation beam (621) comprises a first portion of the wavelength band and the first reflected radiation beam (631) comprises a second portion of the wavelength band. Such a first portion of the wavelength band may then be understood as a first selected color or a first selected range of colors. Such a second portion of the wavelength band may then be understood as comprising the colors or range of colors which were not selected in the first filtering. This can also be referred to as the remaining wavelengths or colors after the first filtering.

The second reflector (642) is configured to receive the first reflected radiation beam (631) and direct the first reflected radiation beam (631) towards the optical filter (650). The optical filter (650) is further configured to depending on a second impinging characteristic of the first reflected beam (631) selectively transmit a second transmitted radiation beam (622). The second transmitted radiation beam (622) comprises a third portion of the wavelength band.

Such a third portion of the wavelength band may then be understood as a second selected color or a second selected range of colors, selected from the remaining wavelengths or colors after the first filtering. In this way the reflected light with the remaining colors is reused. By doing this second filtering more efficient use is made of the broadband radiation.

An impinging characteristic as used in this application, such as for example the first impinging characteristic of the radiation beam (610) or the second impinging characteristic of the first reflected beam (631), can for example be a selectable position on the optical filter (650).

Such an optical filter (650) where the impinging characteristic is a selectable position on the optical filter (650) can for example be an optical filter having varying filtering characteristics at varying locations. Such an optical filter may also be referred to as a position dependent filter. A selectable position can then correspond to a different position on the optical filter resulting in a varying filtering characteristic resulting in a varying portion of the wavelength band being transmitted (such as the forementioned first, second or third portion). An example of such an optical filter is a linearly varying optical filter, also referred to as a continuously variable optical filter. Another example of such an optical is a filter being subdivided in sections of varying filtering characteristics. It is not necessary that in these examples of optical filters each position of subdivided section has a unique filtering characteristic. In other words, a first position and second position, or first subdivided section and second subdivided section may have substantially the same filtering characteristic.

Such optical filters may also be constructed as a filter pair, for example a first continuously variable optical filter is a long wavelength pass filter, and a second continuously variable optical filter is a short wavelength pass filter. It may be of interest to put the short pass filter upstream of the long pass filter. It may also be of interest to put the long pass filter upstream of the short pass filter.

Such a continuously variable optical filter may have a transition from blocking to transmitting at longer and longer wavelengths in a first direction and may be referred to a wavelength selecting direction. The long pass filter and the short pass filter may be offset from one another in the wavelength selecting direction. The offset between the long pass filter and the short pass filter affects a bandwidth of radiation which is transmitted by the filters.

Alternatively, a different optical filter arrangement may be used. For example, a bandpass filter may be used. Different locations on the bandpass filter may be transmissive for different wavelengths of radiation. The optical filter, instead of having wavelength transmission that is continuously variable, may have wavelength transmission that varies in a series of steps. In general, any form of optical filter that selectively filters different wavelengths of a radiation beam at different locations may be used.

The impinging characteristic can for example also be an angle of incidence of the radiation beam (610) on the optical filter (650).

The impinging characteristic can for example also be an angle of incidence of the first reflected beam (631) on the optical filter (650).

Such an optical filter (650) where the impinging characteristic is an angle of incidence on the optical filter (650) can for example be an angle of incidence tunable filter (AOITF) or an angle-tuned thin-film filter. These may also be referred to as an angle of incidence dependent filter. Depending on the angle of incidence of a beam with respect to the surface of the filter, such an AOITF transmits different portions of wavelength band (such as the forementioned first, second or third portion). It is however not necessary that each incremental change of angle of incidence result in the transmitting of a different portion of the wavelength band. There may be several regions of the filter resulting in substantially the same portion of the wavelength band transmitting.

Furthermore, it will be appreciated that it's also possible for an optical filter (650) to comprise of both regions, parts or subdivisions being position dependent and angle of incidence dependent.

Generally such an optical filter can be referred to as an optical filter arrangement or an arrangement of spectral filters. Such an arrangement of spectral filters is further described in patent publication document WO 2025131447 Al and patent publication document WO 2025172038 Al which are incorporated here by reference. Furthermore in such an arrangement of spectral filters, which can also be referred to as color filters, the spectral filters can for example be, but are not limited to, linear variable filters, continuously variable optical filters, angle of incidence dependent filters, interference filters, dielectric filters or acousto-optic filters. Such filters will have a filtering characteristic or spectral properties enabling the filtering function.

In an embodiment the first impinging characteristic of the radiation beam (610) or the second impinging characteristic of the first reflected beam (631) are the same. For example, both are a selectable position on the optical filter (650). In another example both are an angle of incidence of radiation beam (610) or the first reflected beam (631) on the optical filter (650).

In another embodiment the first impinging characteristic of the radiation beam (610) or the second impinging characteristic of the first reflected beam (631) are different. For example, the first impinging characteristic of the radiation beam (610) is a selectable position on the optical filter (650) and the second impinging characteristic of the first reflected beam (631) is an angle of incidence of the first reflected beam (631) on the optical filter (650). Or vice versa, in an example, the first impinging characteristic of the radiation beam (610) is an angle of incidence of radiation beam (610) on the optical filter (650) and the second impinging characteristic of the first reflected beam (631) is a selectable position on the optical filter (650).

As way of example figure 6(b) depicts a similar color selection module (601) as depicted and described on figure 6(a). This figure depicts a change in the first impinging characteristic of the radiation beam (610) as controlled by the first reflector (641). As further explained below this can result in, for example, a different selectable position on the optical filter (650) or, for example, a different angle of incidence on the optical filter (650). This then results in another first transmitted radiation beam (621') and another first reflected radiation beam (631') with respect to the first transmitted radiation beam (621) and with respect to the first reflected radiation beam (631) as depicted in figure 6(a). This can then be understood as resulting in another first selected color or range of colors and another range of remaining colors.

Similarly, as schematically depicted in figure 6(b), a change in the second impinging characteristic of the another first reflected beam (631') results in a change of a another second transmitted radiation beam (622') with respect to the second transmitted radiation beam (622) as depicted in figure 6(a). This can then be understood as resulting in another second selected color or second selected range of colors.

It will be appreciated that the described embodiments in this description are not limited to the described first andsecond transmitted radiation beams. There may be a further, not shown, third, fourth, fifth and so forth transmitted radiation beams. Furthermore, it will be appreciated that the described embodiments in this description are not limited to the described first reflected radiation beam. There may be a further, not shown, third, fourth, fifth and so forth reflected radiation beams. Similarly, the described embodiments in this description are not limited to the described associated impinging characteristics of the radiation beam and the first reflected radiation beam.

As way of example figure 7 depicts a color selection module (701) which is a variation of the color selection module (601) as shown an described of figure 6(a) . The difference with figure 6(a) is that the second reflector (642) may have selectable configurations. These selectable configurations are similar as described above for the first reflector (641). Depending on the selectable configuration of the first reflector (641) and the resulting impinging characteristic of the radiation beam (610) on the optical filter (650) this results in a further first transmitted radiation beam (621"). Similarly as described above this then also results in a further first reflected radiation beam (631").

With the selectable configurations of the second reflector (642) the optical filter (650) is then further configured to selectively transmit a further second transmitted radiation beam (622") comprising a third portion of the wavelength band depending on the second impinging characteristic of the further first reflected radiation beam (631").

In an embodiment, any of the color selection modules described may further comprise a routing module (660) configured to receive and transmit one or more of the first and/or second transmitted radiation beams (621, 622, 621', 622', 621", 622") towards an output (670). These transmitted radiation beams can then for example be used further as measurement radiation as described above. The measurement radiation can then make use of the selected first and second colors, or first selected range and second selected range of colors. It will be appreciated that the disclosed embodiments in this specification are not limited to the first selected and second selected colors or ranges of colors. A third, fourth, fifth and so forth selected color or range of colors may be obtained and used in or for the measurement radiation.

Depending on the requirements of the output one, a subset or all of the first and/or second transmitted radiation beams (621, 622, 621', 622', 621", 622") are transmitted towards the output. For example, it may be of interest to receive and transmit the first and second transmitted radiation beams (621, 622) comprising respectively the first and the second portion of the wavelength band towards the output. In this way substantially simultaneously two transmitted radiation beams with different portions of the wavelength band can be obtained and used. This can then be understood as two different colors or color ranges, for example a first selected and second selected, can be used in the measurement radiation substantially simultaneously.

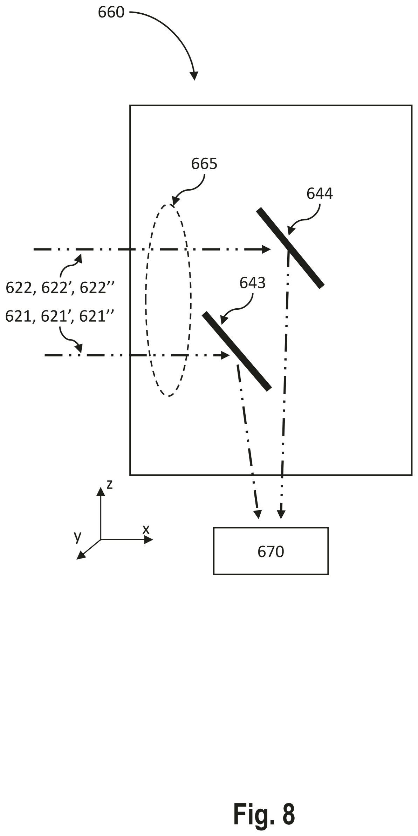

Figure 8 schematically depicts that, in an example, the routing module comprising optical elements (643, 644) configured for manipulating the one or more transmitted radiation beams (621, 622, 621', 622', 621", 622") towards the output. The optical elements can for example be a third reflector (643) and a fourth reflector (644). In this example the third reflector (643) is configured for receiving and directing the first transmitted radiation beam (621) towards the output (670) and the fourth reflector (644) is configured for receiving and directing the second transmitted radiation beam (622) towards the output (670).

To manipulate the first and/or second transmitted radiation beams (621, 622, 621', 622', 621", 622") towards the output (670) the third reflector (643) and fourth reflector (644) may be actuatable to steer the received first and/or second transmitted radiation beams (621, 622, 621', 622', 621", 622") towards the output (670). This may be required to align the transmitted radiation beams with the output and prevent or reduce transmission losses.

In an example the third reflector (643) or the fourth reflector (644) can also receive and transmit one of the transmitted radiation beams away from the output (670), for example towards a (not shown) beam dump. In this way the routing module comprising optical elements can also selectively transmit one or more of the transmitted radiation beams.

Although figure 8 suggests that the transmitted radiation beams all are transmitted to a single output (670), it will be appreciated that it's also possible to transmit one or more of the transmitted radiation beams to an additional (not shown) output. In this way a first selected color or color range can be transmitted to a first output and a second selected color or color range can be transmitted to a second output.

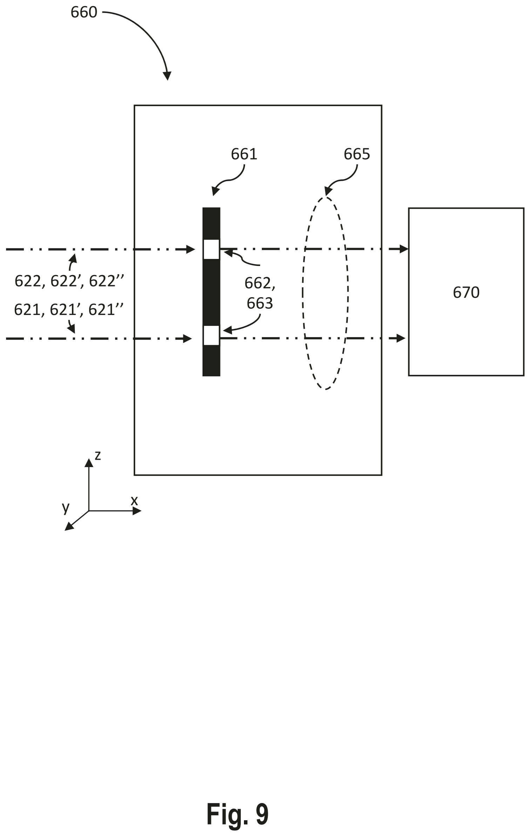

Figure 9 schematically depicts that, in an example, the routing module is further configured to selectively transmit one or more of the first and/or second transmitted radiation beams (621, 622, 621', 622', 621", 622") towards the output (670), the routing module comprising a shutter array (661), the shutter array (661) comprising at least two shutters (662, 663) wherein each shutter is selectively operable between a transmissive mode and non-transmissive mode, wherein the non-transmissive mode includes at least one of substantial absorption or substantial reflection of the transmitted radiation beams it receives. In this way the routing module can selectively choose which of the first selected color or range of colors, or second selected color or range of colors gets transmitted for further use in measurement radiation.

In an embodiment where the routing module comprises the shutter array, the shutter array comprises at least the number of shutters as the number of transmitted radiation beams. It can for example be imagined that for a specific application a specific number of selected colors are required.

In an embodiment the output (670) as described for any of the above embodiments comprises an optical fiber. Such an optical fiber may be used to further transport, transmit or guide one, a subset, or all of the first and/or second transmitted radiation beams (621, 622, 621', 622', 621", 622") towards a further module, apparatus or device. These transmitted radiation beams may then for example be used as the measurement radiation described above. Again, it will also be understood that these first and/or second transmitted radiation beams comprise, respectively, a first selected color or range of colors and a second selected color or range of colors.

Such an optical fiber may comprise a single core. Such an optical fiber may also comprise multiple cores. For example it may be of interest to transmit the first transmitted radiation beam with the routing module towards a first core of the optical fiber and transmit the second transmitted radiation beam with the routine module towards a second, different, core of the optical fiber. This eventually enables splitted use of either of the transmitted radiation beams, and eventually the different selected colors or ranges of colors. It may also be of interest to transmit both the first and second transmitted radiation beams into the same core.

Examples of optical fibers are hollow-core fibers, solid-core fibers, photonic crystal fibers or any other optical fiber suitable for transporting, transmitting or guiding radiation beams as described in this disclosure. Such an optical fiber may be of the single-mode or multimode type.

In an embodiment the output (670) comprises a first output optical fiber and a second output optical fiber. In this case the routing module manipulates the first transmitted radiation beam (621) towards first output optical fiber and the second transmitted beam (622) towards the second output optical fiber.

It will be appreciated that also a combination of optical elements as described above and a shutter array as described above can be comprised in the routing module.

Additionally, the routing module can for example also attenuate one or more of the first and/or second transmitted radiation beams (621, 622, 621', 622', 621", 622") by using for example a neutral density filter.

In an embodiment the routing module (660) comprises a lens element (665) configured for focusing one or more of the first and/or second transmitted radiation beams (621, 622, 621', 622', 621", 622") towards the output (670). Such a lens element (665) focuses or converges the transmitted radiation beams onto or into the output (670).to improve the coupling into the output (670). This may result in a more efficient transfer of the radiation of the beams and reduce intensity losses due to misalignment of the transmitted radiation beams onto or into the output (670).

This lens element (665) can for example be positioned downstream of the routing module (660) comprising the shutter array (661). Alternatively, this lens element can for example be positioned upstream of the routing module (660) comprising the third reflector (643) and the fourth reflector (644).

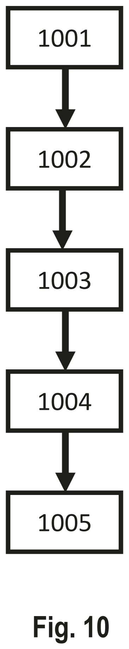

Figure 10 schematically depicts an overview of a method for filtering a radiation beam (610) having radiation comprising a wavelength band, the method comprising: receiving (1001) and directing the radiation beam (610) with a first reflector (641) towards an optical filter (650), the first reflector (641) having selectable configurations. Controlling (1002) a first impinging characteristic of the radiation beam (610) with the selectable configurations of the first reflector (641). Selectively transmitting (1003) a first transmitted radiation beam (621) with the optical filter (650) depending on the first impinging characteristic of the radiation beam (610), the first transmitted radiation beam comprising a first portion of the wavelength band. Selectively reflecting (1004) a first reflected radiation beam (631) comprising a second portion of the wavelength band. Receiving and directing (1005) the first reflected radiation beam (631) towards the optical filter (650). Selectively transmitting a second transmitted radiation beam (622) with the optical filter (650) depending on a second impinging characteristic of the first reflected radiation beam (631), the second transmitted radiation beam (622) comprising a third portion of the wavelength band.

Any of the embodiments as described herein may be implemented in any of the earlier described metrology and/or inspection apparatuses, tools or devices to be used as a color selection module. Similarly any of the embodiments as described herein may be implemented in a lithographic apparatus as earlier described. Similarly any metrology and/or inspection apparatuses, tools or devices implemented with a color selection module as described herein may be implemented in a lithographic apparatus as earlier described. Similarly, such a lithographic apparatus with any metrology and/or inspection apparatuses, tools or devices implemented with a color selection module may be implemented in a lithographic cell as earlier described. Similarly any of the embodiments as described herein may be implemented in a lithographic cell.

Further embodiments are disclosed in the subsequent list of numbered clauses:
1. A color selection module for filtering a radiation beam having radiation comprising a wavelength band, the color selection module comprising
   a first reflector; a second reflector; an optical filter, wherein
   the first reflector has selectable configurations and is configured to receive the radiation beam and direct the radiation beam towards the optical filter, the selectable configurations controlling a first impinging characteristic of the radiation beam, the optical filter is configured to depending on the first impinging characteristic of the radiation beam selectively transmit a first transmitted radiation beam comprising a first portion of the wavelength band and reflect a first reflected radiation beam comprising a second portion of the wavelength band;
   the second reflector is configured to receive the first reflected radiation beam and direct the first reflected radiation beam towards the optical filter, the optical filter is further configured to depending on a second impinging characteristic of the first reflected beam selectively transmit a second transmitted radiation beam comprising a third portion of the wavelength band.
2. A color selection module as defined in clause 1 wherein the first impinging characteristic of the radiation beam and/or the second impinging characteristic of the first reflected beam is a selectable position on the optical filter or is an angle of incidence of the radiation beam or the first reflected radiation beam on the optical filter.
3. A color selection module as defined in any of the previous clauses wherein the selectable configurations comprise a pre-configured position of the first reflector or the selectable configurations comprise a continuous range of positions of the first reflector.
4. A color selection module as defined in any of the previous clauses wherein the second reflector has selectable configurations and the optical filter is further configured to selectively transmit the second transmitted radiation beam comprising the third portion of the wavelength band depending on the second impinging characteristic of the first reflected radiation beam.
5. A color selection module as defined in any of the previous clauses further comprising a routing module configured to receive and transmit one or more of the transmitted radiation beams towards an output.
6. A color selection module as defined in clause 5 wherein the routing module comprises optical elements configured for manipulating the one or more transmitted radiation beams towards the output.
7. A color selection module as defined in clause 6 wherein the routing module further comprises a third reflector and a fourth reflector, wherein the third reflector is configured for receiving and directing the first transmitted radiation beam towards the output and wherein the fourth reflector is configured for receiving and directing the second transmitted radiation beam towards the output.
8. A color selection module as defined in clause 5 or 6 wherein the routing module is further configured to selectively transmit one or more of the transmitted radiation beams towards the output, the routing module comprising a shutter array, the shutter array comprising at least two shutters wherein each shutter is selectively operable between a transmissive mode and non-transmissive mode, wherein the non-transmissive mode includes at least one of substantial absorption or substantial reflection of the transmitted radiation beams it receives.
9. A color selection module as defined in clause 8 wherein the shutter array comprises at least the number of shutters as the number of transmitted radiation beams.
10. A color selection module as defined in any of the clauses 5 until 9 wherein the routing module further comprises a lens element configured for focusing the transmitted radiation beams towards the output.
11. A color selection module as defined in any of the clauses 5 until 10 wherein the output comprises an optical fiber.
12. A color selection module as defined in any of the clauses 5 until 11 wherein the output comprises a first output optical fiber and a second output optical fiber, and wherein the routing module manipulates the first transmitted radiation beam towards first output optical fiber and the second transmitted radiation beam towards the second output optical fiber.
13. A color selection module as defined in clause 11 wherein the routing module manipulates the first transmitted radiation beam towards the optical fiber and the second transmitted radiation beam towards the optical fiber.
14. A color selection module as defined in any of the previous clauses wherein the optical filter is a position dependent filter or the optical filter is an angle of incidence dependent filter.
15. A color selection module as defined in any of the previous clauses wherein at least one of the reflectors comprises a galvanometer mirror.
16. A metrology tool or inspection tool comprising the color selection module as defined in any of the previous clauses.
17. A lithographic apparatus comprising the color selection module as defined in any of the clauses 1 till 15 or the metrology tool or inspection tool as defined in clause 16.
18. A lithographic cell comprising the color selection modules as defined in any of the clauses 1 till 15 or the lithographic apparatus as defined in clause 17.
19. A method for filtering a radiation beam having radiation comprising a wavelength band, the method comprising:
   - receiving and directing the radiation beam with a first reflector towards an optical filter, the first reflector having selectable configurations;
   - controlling a first impinging characteristic of the radiation beam with the selectable configurations of the first reflector;
   - selectively transmitting a first transmitted radiation beam with the optical filter depending on the first impinging characteristic of the radiation beam, the first transmitted radiation beam comprising a first portion of the wavelength band;
   - selectively reflecting a first reflected radiation beam comprising a second portion of the wavelength band;
   - receiving and directing the first reflected radiation beam towards the optical filter;
   - selectively transmitting a second transmitted radiation beam with the optical filter depending on a second impinging characteristic of the first reflected radiation beam, the second transmitted radiation beam comprising a third portion of the wavelength band.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A color selection module for filtering a radiation beam having radiation comprising a wavelength band, the color selection module comprising
a first reflector; a second reflector; an optical filter, wherein
the first reflector has selectable configurations and is configured to receive the radiation beam and direct the radiation beam towards the optical filter, the selectable configurations controlling a first impinging characteristic of the radiation beam, the optical filter is configured to depending on the first impinging characteristic of the radiation beam selectively transmit a first transmitted radiation beam comprising a first portion of the wavelength band and reflect a first reflected radiation beam comprising a second portion of the wavelength band;
the second reflector is configured to receive the first reflected radiation beam and direct the first reflected radiation beam towards the optical filter, the optical filter is further configured to depending on a second impinging characteristic of the first reflected beam selectively transmit a second transmitted radiation beam comprising a third portion of the wavelength band.

2. A color selection module as claimed in claim 1 wherein the first impinging characteristic of the radiation beam and/or the second impinging characteristic of the first reflected beam is a selectable position on the optical filter or is an angle of incidence of the radiation beam or the first reflected radiation beam on the optical filter.

3. A color selection module as claimed in any of the previous claims wherein the selectable configurations comprise a pre-configured position of the first reflector or the selectable configurations comprise a continuous range of positions of the first reflector.

4. A color selection module as claimed in any of the previous claims wherein the second reflector has selectable configurations and the optical filter is further configured to selectively transmit the second transmitted radiation beam comprising the third portion of the wavelength band depending on the second impinging characteristic of the first reflected radiation beam.

5. A color selection module as claimed in any of the previous claims further comprising a routing module configured to receive and transmit one or more of the transmitted radiation beams towards an output.

6. A color selection module as claimed in claim 5 wherein the routing module comprises optical elements configured for manipulating the one or more transmitted radiation beams towards the output.

7. A color selection module as claimed in claim 5 or 6 wherein the routing module is further configured to selectively transmit one or more of the transmitted radiation beams towards the output, the routing module comprising a shutter array, the shutter array comprising at least two shutters wherein each shutter is selectively operable between a transmissive mode and non-transmissive mode, wherein the non-transmissive mode includes at least one of substantial absorption or substantial reflection of the transmitted radiation beams it receives.

8. A color selection module as claimed in any of the claims 5 until 7 wherein the output comprises an optical fiber.

9. A color selection module as claimed in any of the claims 5 until 8 wherein the output comprises a first output optical fiber and a second output optical fiber, and wherein the routing module manipulates the first transmitted radiation beam towards first output optical fiber and the second transmitted radiation beam towards the second output optical fiber.

10. A color selection module as claimed in any of the previous claims wherein the optical filter is a position dependent filter or the optical filter is an angle of incidence dependent filter.

11. A color selection module as claimed in any of the previous claims wherein at least one of the reflectors comprises a galvanometer mirror.

12. A metrology tool or inspection tool comprising the color selection module as claimed in any of the previous claims.

13. A lithographic apparatus comprising the color selection module as claimed in any of the claims 1 till 11 or the metrology tool or inspection tool as claimed in claim 12.

14. A lithographic cell comprising the color selection modules as claimed in any of the claims 1 till 11 or the lithographic apparatus as claimed in claim 13.

15. A method for filtering a radiation beam having radiation comprising a wavelength band, the method comprising:
- receiving and directing the radiation beam with a first reflector towards an optical filter, the first reflector having selectable configurations;
- controlling a first impinging characteristic of the radiation beam with the selectable configurations of the first reflector;
- selectively transmitting a first transmitted radiation beam with the optical filter depending on the first impinging characteristic of the radiation beam, the first transmitted radiation beam comprising a first portion of the wavelength band;
- selectively reflecting a first reflected radiation beam comprising a second portion of the wavelength band;
- receiving and directing the first reflected radiation beam towards the optical filter;
- selectively transmitting a second transmitted radiation beam with the optical filter depending on a second impinging characteristic of the first reflected radiation beam, the second transmitted radiation beam comprising a third portion of the wavelength band.
